# EUROPEAN PATENT SPECIFICATION

(11) **EP 2 106 924 B1**
(45) Date of publication and mention of the grant of the patent: **29.06.2011**
(21) Application number: 08103210.4
(22) Date of filing: 31.03.2008
(51) Int. Cl.: B41N 3/06, B41N 3/08, G03F 7/42

(54) **A method for treating a lithographic printing plate**
Verfahren zur Behandlung einer lithografischen Druckplatte
Procédé pour traiter une plaque d'impression lithographique

(43) Date of publication of application: 07.10.2009
(73) Proprietor: Agfa Graphics N.V., 2640 Mortsel (BE)
(72) Inventor: Maessen, Peter, 2640, Mortsel (BE); Mertens, Patrick, 2640, Mortsel (BE)

(56) References cited:
- EP-A- 0 498 545
- WO-A-01/74984
- WO-A-2005/113240
- WO-A-2008/003161
- JP-A- 2003 054 150
- JP-A- 2003 313 596
- JP-A- 2007 196 557
- US-A- 4 399 243
- US-A- 5 340 495
- US-B1- 6 544 348

## Description

### FIELD OF THE INVENTION

The present invention relates to a method for treating a lithographic printing plate.

### BACKGROUND OF THE INVENTION

Lithographic printing presses use a so-called printing master such as a printing plate which is mounted on a cylinder of the printing press. The master carries a lithographic image on its surface and a print is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Printing masters are generally obtained by the image-wise exposure and processing of an imaging material called plate precursor. In addition to the well-known photosensitive, so-called pre-sensitized plates, which are suitable for UV contact exposure through a film mask, also heat-sensitive printing plate precursors have become very popular in the late 1990s. Such thermal materials offer the advantage of daylight stability and are especially used in the so-called computer-to-plate method wherein the plate precursor is directly exposed, i.e. without the use of a film mask. The material is exposed to heat or to infrared light and the generated heat triggers a (physico-)chemical process, such as ablation, polymerization, insolubilization by cross linking of a polymer, heat-induced solubilization or particle coagulation of a thermoplastic polymer latex.

The most popular thermal plates form an image by a heat-induced solubility difference in an alkaline developer between exposed and non-exposed areas of the coating. The coating typically comprises an oleophilic binder, e.g. a phenolic resin, of which the rate of dissolution in the developer is either reduced (negative working) or increased (positive working) by the image-wise exposure. During processing, the solubility differential leads to the removal of the non-image (non-printing) areas of the coating, thereby revealing the hydrophilic support, while the image (printing) areas of the coating remain on the support. Typical examples of such plates are described in e.g. EP-A 625728, 823327, 825927, 864420, 894622 and 901902. Negative working embodiments of such thermal materials often require a pre-heat step between exposure and development as described in e.g. EP-625,728.

Negative working plate precursors which do not require a pre-heat step may contain an image-recording layer that works by heat-induced particle coalescence of a thermoplastic polymer particle (latex), as described in e.g. EP-As 770 494, 770 495, 770 496 and 770 497. These patents disclose a method for making a lithographic printing plate comprising the steps of (1) image-wise exposing an imaging element comprising hydrophobic thermoplastic polymer particles dispersed in a hydrophilic binder and a compound capable of converting light into heat, (2) and developing the image-wise exposed element by applying fountain and/or ink.

Some of these thermal processes enable plate-making without wet processing and are for example based on ablation of one or more layers of the coating. At the exposed areas the surface of an underlying layer is revealed which has a different affinity towards ink or fountain than the surface of the unexposed coating.

Other thermal processes which enable plate-making without wet processing are for example processes based on a heat-induced hydrophilic/oleophilic conversion of one or more layers of the coating so that at exposed areas a different affinity towards ink or fountain is created than at the surface of the unexposed coating.

US 5,380,453 discloses a composition for removing ink from a printing machine comprising 50-99.75 %wt of a C₁-C₅ alkyl ester of an aliphatic C₈-C₂₂ monocarboxylic acid and mixtures thereof, 0.25-10 %wt oil in water emulsifier such as C₁₂-C₂₂ fatty alcohols ethoxylated with 7-14 ethoxy groups, and preferably a vegetable oil in an amount of up to 15 %wt.

US 5,340,495 discloses an ink cleaner composition for removing ink from parts of a printing press comprising 60%-95 %wt of a methyl ester of a C₈-C₂₂ fatty acid; and 5%-40 %wt of an ethoxylated C₄-C₁₀ alcohol having a molar ratio of ethylene oxide to alcohol of 2:1 to 8:1.

US 4,997,588 discloses a cleaner for lithographic printing plates free of aromatic hydrocarbons consisting essentially of 3.0 to 35.0 %wt of ethoxylates or propoxylates of C₁ to C₄ alcohols, 0.5 to 7.0%wt sodium metasilicate, 0.25 to 6.0 %wt of a non-ionic surfactant selected from the group consisting of polyoxy aryl ethers and 52.0% to 96.25 %wt water.

US 6,544,348 discloses a cleaning composition consisting of a microemulsion comprising water, a surfactant such as 1-20 %wt polyethylene glycol monoalkyl ether, and a water-immiscible organic solvent.

Before, during and after the printing step, a lithographic printing plate is in general treated with various liquids for improving the lithographic properties of the image and non-image areas. Such liquids are applied for example to improve the hydrophilic properties of the non-image areas and to protect, restore or even enhance the hydrophobicity of the image areas. It is of high importance that these fluids, commonly referred to as plate treating liquids, do not deteriorate the image and/or the non-image areas throughout and well after their application. Due to the bivalent nature of such a treatment - i.e. improving both hydrophilic and hydrophobic areas - the treating liquid typically contains both water and organic solvent(s) and is thus an emulsion; preferably an oil-in-water (O/W) emulsion.

The cleaning strength or so-called "ink solvency" of plate cleaning liquids or plate cleaners - i.e. the ability to remove ink from a plate - is mainly determined by the composition of the plate cleaner and more specificly, by the concentration and/or nature of the organic solvent. Aromatic hydrocarbon solvents are preferred over aliphatic hydrocarbon solvents as they exhibit a very good ink solvency. Commonly used aromatic hydrocarbon solvents are mixtures of C₉-C₁₀ alkylbenzene hydrocarbons. However, cleaning liquids containing such aromatic hydrocarbons have a low flashpoint and thus create a high risk of explosure to the cleaning liquids not only in the pressroom environment but also during transport. Morover, C₉-C₁₀ alkylbenzene hydrocarbons usually contain ethylbenzene which is not only a toxic compound but is also a suspected carcinogenic compound. The flashpoint of C₉-C₁₀ aromatic alkylbenzene hydrocarbon solvents can for example be increased by mixing them with aliphatic hydrocarbon solvents with a higher flashpoint. However, their ink solvency considerably reduces and the solvent level of such a plate cleaner significantly increases which is unfavourable from both an environmental and economic point of view. To meet high standards of health and safety, esters of vegetable oils and/or esters of vegetable oils combined with aliphatic hydrocarbons have been succesfully used in the prior art; however, their cleaning strength is still not as good as the cleaning strength of aromatic hydrocarbons. There is thus still an urgent need for alternative, efficient treating liquids which meet high standards of health and safety.

### SUMMARY OF THE INVENTION

It is an object of the present invention to provide an alternative cleaning liquid for a printing plate which has an excellent ink solvency and which complies with high health and safety requirements.

This object is realized by claim 1, i.e. a method for cleaning a lithographic printing plate comprising the step of applying a liquid to the plate including
- an aqueous phase;
- a solvent phase which is present in the liquid in an amount ≤ 40%wt;
- and one or more compound(s) having the following formula I:

   R¹-O-(Y)ₙ-H

   wherein
   R¹ is a methyl group, an ethyl group, a propyl group such as a n-propyl and isopropyl group or a butyl group such as a t-butyl and n-butyl group;
   Y represents -CH₂-CHR²-O- with R² = hydrogen or an alkyl group and/or mixtures thereof;
   and n is an integer ≥ 10.

Other features, elements, steps, characteristics and advantages of the present invention will become more apparent from the following detailed description of preferred embodiments of the present invention.

### DETAILED DESCRIPTION OF THE INVENTION

The treating liquid used in the present invention, also referred to as *cleaning liquid* or *plate cleaner,* is an emulsion, preferably an oil-in-water emulsion, comprising an aqueous phase and a solvent phase. The cleaning liquid preferably has a flash point above 60°C. The total level of the solvent phase in the emulsion is ≤ 40%wt, preferably ≤ 35%wt, more preferably ≤ 30%wt. The solvent phase ranges between 10%wt - 40%wt, more preferably between 15%wt - 35%wt and most preferably bewteen 20%wt and 30%wt. The emulsion preferably contains ≥ 60%wt of water, more preferably the level of water ranges between 60%wt and 90%wt, more preferably between 65%wt and 85%wt and most preferably between 70%wt and 80%wt.

The cleaning liquid contains one or more compound(s) having the following formula I:

R¹-O-(Y)ₙ-H

wherein
R¹ is a methyl group, an ethyl group, a propyl group such as a n-propyl and isopropyl group or a butyl group such as a t-butyl and n-butyl group;
Y represents -CH₂-CHR²-O- with R² = hydrogen or an alkyl group and/or mixtures thereof;
and n is an integer ≥ 10.

Suitable alkyl groups are a methyl, ethyl, n-propyl, isopropyl or butyl group. Preferably n ≤ 100, more preferably n ≤ 80 and most preferably n ≤ 60. Y is preferably ethylene oxide (EO, R²=H), propylene oxide (PO, R²=methyl) or mixtures thereof. The molar fraction of EO in the EO/PO mixture is preferably ≤ 0.5 and most preferably ≤ 0.25. Most preferably Y is PO.

The compound with formula I is preferably used in the cleaning liquid within the range of 0.05%wt to 50%wt, more preferably between 1%wt and 30%wt and most preferably between 2%wt and 25%wt.

The solvent phase contains a mixture of one or more aliphatic hydrocarbon solvents and/or esters of vegetable oils. The solvent phase preferably does not contain aromatic hydrocarbon solvents.

The aliphatic hydrocarbons are preferably selected from C₇-C₁₄ aliphatic hydrocarbons, however fractions of lower and/or higher hydrocarbons may be present such as for example C₅-C₆ and/or C₁₅-C₁₈ aliphatic hydrocarbons. They may be linear, branched or cyclic and preferably have a flash point above 60°C. Specific examples include EXXSOL D-60^{™} Exxsol D220/230^{™} and Exxsol D220/240^{™}, commercially available from ExxonMobil Chemical and SHELLSOL D-60^{™}, commercially available from Shell Chemicals.

The esters of vegetable oils are preferably alkyl esters of saturated or unsaturated vegetable oils containing 8 to 22 carbon atoms. Preferred oils for esterification include for example soy bean oil, olive oil, rapeseed oil, sunflower oil, cottonseed oil, palm oil, palm kernel oil and coconut oil, and mixtures thereof. The esters of vegetable oils or mixtures thereof are preferably present in an amount ranging between 0-40%wt, more preferably ranging between 0-25%wt and most preferably between 0.05-15%wt.

In the embodiment were both aliphatic hydrocarbons and esters of vegetable oils are present in the cleaning liquid, the weight ratio of the aliphatic hydrocarbons to the esters of vegetable oils in the solvent phase ranges preferably between 5/1 to 1/5, more preferably between 3/1 to 1/3. Most preferably, the cleaning liquid contains aliphatic hydrocarbons and esters of vegetable oils in a 3/1 ratio. In a particularly preferred embodiment, the solvent phase contains only aliphatic hydrocarbons.

The cleaning liquid may further contain surfactant(s) which provides stability to the emulsion. The surfactant(s) may be anionic, cationic or non-ionic and may be present in the aqueous phase, the solvent phase or in both phases of the emulsion. It may also be present at the interface between both phases. Non-ionic surfactants such as alkyl (poly)glucoside provides already at a very low level stability to the emulsion. They are preferably used within the range of 0-10%wt, more preferably within the range of 0-5%wt and most preferably within the range of 0.5%wt to 1.6%wt. Suitable examples of alkyl (poly)glucosides which are commercially available include, but are not limited to are GLUCOPON^{™} products available from Cognis such as for example Glucopon 425 HH^{™}, Glucopon 600 EC^{™}, Glucopon 600 CSUP^{™}, Glucopon 625 UP^{™} and Glucopon 625 EC^{™}. More details concerning alkyl (poly)glucosides can be found in unpublished patent application EP 07110156.2.

As known in the art other suitable additives may be present in the cleaning liquid - in the solvent phase and/or in the aqueous phase - and include for example hydrophilisers such as sorbitol or glycerol, chelating agents, compounds comprising at least one acid group such as for example phosphoric acid, citric acid, gluconic acid, glycolic acid or polyvinylphosphonic acid, biocides, buffers, pH adjusters like mineral acids or bases, corrosion inhibitors, antifoaming agents, other surfactants, desensitizing agents such as nitrate salts and/or water-soluble polymers with an excellent film forming ability such as polyvinyl alcohol, polyvinylpyrrolidone, partially hydrolyzed polyvinyl acetate, protective agents, fatty acid esters such as alkylesters of fatty acids, dyes, colorants, fragrances, antioxidants, preservatives such as phenol and derivatives thereof, thickening agents such as xanthane gum, gelatin, gum arabic, various starches, carbohydrates or cellulose derivatives such as carboxymethyl cellulose, methyl or ethyl cellulose, hemicellulose, hydroxyethyl cellulose.

The cleaning liquid used in the method of the present invention is applied to a printing plate; it may be applied before, after and/or during the printing step. The cleaning liquid is generally used to remove ink and debris from the plate, to desensitize the non-image areas and to restore the hydrophilic properties of the non-image areas, which upon time may become less able to repel ink and may tend to retain some ink - known in the art as scumming. An efficient plate cleaner removes ink, dirt, oxidation spots, smudge and/or other imperfections without scratching or abrading the plate. The liquid can also be used to remove staining formed at any stage from plate making through printing.

The treating liquids may be applied by for example wiping the printing plate with e.g. a cotton pad or sponge soaked with the treating liquid before and/or after mounting the plate on the press and also during and/or after the press run. The cotton pad or sponge may optionally be wetted with fountain solution before and/or after they are soaked with the treating liquid. The wiping may be combined with mechanical rubbing, e.g. by using a (rotating) brush. Alternatively, the treating liquid may be applied by spraying, dipping or coating it on to the printing plate. Various coating techniques, such as dip coating, spray coating or "on the fly" coating (during printing), slot coating, reverse roll coating or electrochemical coating may be employed; most preferred are dip and spray coating.

The lithographic printing plate used in the present invention comprises a support which has a hydrophilic surface or which is provided with a hydrophilic layer. The support may be a sheet-like material such as a plate or it may be a cylindrical element such as a sleeve which can be slid around a print cylinder of a printing press. Preferably, the support is a metal support such as aluminum or stainless steel. The support can also be a laminate comprising an aluminum foil and a plastic layer, e.g. polyester film.

A particularly preferred lithographic support is an electrochemically grained and anodized aluminum support. The aluminum support has usually a thickness of about 0.1-0.6 mm. However, this thickness can be changed appropriately depending on the size of the printing plate used and/or the size of the plate-setters on which the printing plate precursors are exposed. The aluminium is preferably grained by electrochemical graining, and anodized by means of anodizing techniques employing phosphoric acid or a sulphuric acid/phosphoric acid mixture. Methods of both graining and anodization of aluminum are very well known in the art.

By graining (or roughening) the aluminum support, both the adhesion of the printing image and the wetting characteristics of the non-image areas are improved. By varying the type and/or concentration of the electrolyte and the applied voltage in the graining step, different type of grains can be obtained. The surface roughness is often expressed as arithmetical mean center-line roughness Ra (ISO 4287/1 or DIN 4762) and may vary between 0.05 and 1.5 µm. The aluminum substrate of the current invention has preferably an Ra value below 0.45 µm, more preferably below 0.40 µm and most preferably below 0.30 µm. The lower limit of the Ra value is preferably about 0.1 µm. More details concerning the preferred Ra values of the surface of the grained and anodized aluminum support are described in EP 1 356 926.

By anodising the aluminum support, its abrasion resistance and hydrophilic nature are improved. The microstructure as well as the thickness of the Al₂O₃ layer are determined by the anodising step, the anodic weight (g/m² Al₂O₃ formed on the aluminium surface) varies between 1 and 8 g/m². The anodic weight is preferably ≥ 3 g/m², more preferably ≥ 3.5 g/m² and most preferably ≥ 4.0 g/m².

An optimal ratio between pore diameter of the surface of the aluminium support and the average particle size of hydrophobic thermoplastic particles which may be provided thereon, may enhance the press life of the printing plate and may improve the toning behavior of the prints. This ratio of the average pore diameter of the surface of the aluminium support to the average particle size of the thermoplastic particles which may be present in the image-recording layer of the coating, preferably ranges from 0.05:1 to 1.0:1, more preferably from 0.10:1 to 0.80:1 and most preferably from 0.15:1 to 0.65:1.

The grained and anodized aluminum support may be subject to a so-called post-anodic treatment to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulphonic acid, polyvinylbenzenesulphonic acid, sulphuric acid esters of polyvinyl alcohol, and acetals of polyvinyl alcohols formed by reaction with a sulphonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from Ciba Speciality Chemicals.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm. More details of preferred embodiments of the base layer can be found in e.g. EP-A 1 025 992.

The lithographic printing plate used in the present invention is obtained by exposing and optionally developing a printing plate precursor comprising a heat and/or light-sensitive coating on a hydrophilic support. The precursor can be negative or positive working, i.e. can form ink-accepting areas at exposed or at non-exposed areas respectively. Below, suitable examples of heat- and light-sensitive coatings are discussed in detail.

### Heat-sensitive printing plate precursors.

The imaging mechanism of thermal printing plate precursors can be triggered by direct exposure to heat, e.g. by means of a thermal head, or by the light absorption of one or more compounds in the coating that are capable of converting light, more preferably infrared light, into heat.

A first suitable example of a thermal printing plate precursor is a precursor based on heat-induced coalescence of hydrophobic thermoplastic polymer particles which are preferably dispersed in a hydrophilic binder, as described in e.g. EP 770 494, EP 770 495, EP 770 497, EP 773 112, EP 774 364, EP 849 090, EP 1 614 538, EP 1 614 539, EP 1 614 540, EP 1 777 067, EP 1 767 349, WO 2006/037716, WO 2006/133741 and WO 2007/045515.

Preferably such an image-recording layer comprises an organic compound, characterised in that said organic compound comprises at least one phosphonic acid group or at least one phosphoric acid group or a salt thereof, as described in WO 2007/045515. In a particularly preferred embodiment the image-recording layer comprises an organic compound as represented by formula II: 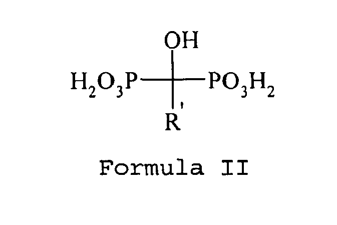 or a salt thereof and wherein R' independently represent hydrogen, an optionally substituted straight, branched, cyclic or heterocyclic alkyl group or an optionally substituted aryl or (hetero)aryl group.

Compounds according to Formula II may be present in the image-recording layer in an amount between 0.05 and 15% by weight, preferably between 0.5 and 10% by weight, more preferably between 1 and 5 % by weight relative to the total weight of the ingredients of the image-recording layer.

In a second suitable embodiment, the thermal printing plate precursor comprises a coating comprising an aryldiazosulfonate homo- or copolymer which is hydrophilic and soluble in the processing liquid before exposure to heat or UV light and rendered hydrophobic and less soluble after such exposure.

Preferred examples of such aryldiazosulfonate polymers are the compounds which can be prepared by homo- or copolymerization of aryldiazosulfonate monomers with other aryldiazosulfonate monomers and/or with vinyl monomers such as (meth)acrylic acid or esters thereof, (meth)acrylamide, acrylonitrile, vinylacetate, vinylchloride, vinylidene chloride, styrene, α-methyl styrene etc. Suitable aryldiazosulfonate monomers are disclosed in EP-A 339393, EP-A 507008 and EP-A 771645 and suitable aryldiazosulfonate polymers are disclosed in EP 507,008, EP 960,729, EP 960,730 and EP1,267,211.

A further suitable thermal printing plate precursor is positive working and relies on heat-induced solubilization of an oleophilic resin. The oleophilic resin is preferably a polymer that is soluble in an aqueous developer, more preferably an aqueous alkaline developing solution with a pH between 7.5 and 14. Preferred polymers are phenolic resins e.g. novolac, resoles, polyvinyl phenols and carboxy substituted polymers. Typical examples of these polymers are described in DE-A-4007428, DE-A-4027301 and DE-A-4445820. The amount of phenolic resin present in the first layer is preferably at least 50% by weight, preferably at least 80% by weight relative to the total weight of all the components present in the first layer.

In a preferred embodiment, the oleophilic resin is preferably a phenolic resin wherein the phenyl group or the hydroxy group is chemically modified with an organic substituent. The phenolic resins which are chemically modified with an organic substituent may exhibit an increased chemical resistance against printing chemicals such as fountain solutions or plate treating liquids such as plate cleaners. Examples of such chemically modified phenolic resins are described in EP-A 0 934 822, EP-A 1 072 432, US 5 641 608, EP-A 0 982 123, WO 99/01795, EP-A 02 102 446, EP-A 02 102 444, EP-A 02 102 445, EP-A 02 102 443, EP-A 03 102 522. The modified resins described in EP-A 02 102 446, are preferred, especially those resins wherein the phenyl-group of said phenolic resin is substituted with a group having the structure -N=N-Q, wherein the -N=N- group is covalently bound to a carbon atom of the phenyl group and wherein Q is an aromatic group.

In the latter embodiment the coating may comprise a second layer that comprises a polymer or copolymer (i.e. (co)polymer) comprising at least one monomeric unit that comprises at least one sulfonamide group. This layer is located between the layer described above comprising the oleophilic resin and the hydrophilic support. Hereinafter, 'a (co)polymer comprising at least one monomeric unit that comprises at least one sulfonamide group' is also referred to as "a sulphonamide (co)polymer". The sulphonamide (co)polymer is preferably alkali soluble. The sulphonamide group is preferably represented by -NR-SO₂-, -SO₂-NR- or -SO₂-NRR' wherein R and R' each independently represent hydrogen or an organic substituent.

Sulfonamide (co)polymers are preferably high molecular weight compounds prepared by homopolymerization of monomeric units containing at least one sulfonamide group or by copolymerization of such monomeric units and other polymerizable monomeric units.

Examples of monomeric units containing at least one sulfonamide group include monomeric units further containing at least one polymerizable unsaturated bond such as an acryloyl, allyl or vinyloxy group. Suitable examples are disclosed in U.S. 5,141,838, EP 1545878, EP 909,657, EP 0 894 622 and EP 1,120,246.

Examples of monomeric units copolymerized with the monomeric units containing at least one sulfonamide group include monomeric units as disclosed in EP 1,262,318, EP 1,275,498, EP 909,657, EP 1,120,246,EP 0 894 622 and EP 1,400,351.

Suitable examples of sulfonamide (co)polymers and/or their method of preparation are disclosed in EP-A 933 682, EP-A 982 123, EP-A 1 072 432, WO 99/63407 and EP 1,400,351. A highly preferred example of a sulfonamide (co)polymer is disclosed in EP 1 604 818 (see general formula (IV) in paragraph [0029] of EP 1 604 818).

The layer comprising the sulphonamide (co)polymer may further comprise additional hydrophobic binders such as a phenolic resin (e.g. novolac, resoles or polyvinyl phenols), a chemically modified phenolic resin or a polymer containing a carboxyl group, a nitrile group or a maleimide group.

The dissolution behavior of the coating of the latter embodiment in the developer can be fine-tuned by optional solubility regulating components. More particularly, development accelerators and development inhibitors can be used. In the embodiment where the coating comprises more than one layer, these ingredients can be added to the first layer, to the second layer and/or to an optional other layer of the coating.

Development accelerators are compounds which act as dissolution promoters because they are capable of increasing the dissolution rate of the coating. For example, cyclic acid anhydrides, phenols or organic acids can be used in order to improve the aqueous developability. Examples of the cyclic acid anhydride include phthalic anhydride, tetrahydrophthalic anhydride, hexahydrophthalic anhydride, 3,6-endoxy-4-tetrahydro-phthalic anhydride, tetrachlorophthalic anhydride, maleic anhydride, chloromaleic anhydride, alpha -phenylmaleic anhydride, succinic anhydride, and pyromellitic anhydride, as described in U.S. Patent No. 4,115,128. Examples of the phenols include bisphenol A, p-nitrophenol, p-ethoxyphenol, 2,4,4'-trihydroxybenzophenone, 2,3,4-trihydroxy-benzophenone, 4-hydroxybenzophenone, 4,4',4"-trihydroxy-triphenylmethane, and 4,4',3",4"-tetrahydroxy-3,5,3',5'-tetramethyltriphenyl-methane, and the like. Examples of the organic acids include sulphonic acids, sulfinic acids, alkylsulfuric acids, phosphonic acids, phosphates, and carboxylic acids, as described in, for example, JP-A Nos. 60-88,942 and 2-96,755. Specific examples of these organic acids include p-toluenesulphonic acid, dodecylbenzenesulphonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, 3,4,5-trimethoxybenzoic acid, 3,4,5-trimethoxycinnamic acid, phthalic acid, terephthalic acid, 4-cyclohexene-1,2-dicarboxylic acid, erucic acid, lauric acid, n-undecanoic acid, and ascorbic acid. The amount of the cyclic acid anhydride, phenol, or organic acid contained in the coating is preferably in the range of 0.05 to 20% by weight, relative to the coating as a whole. Polymeric development accelerators such as phenolic-formaldehyde resins comprising at least 70 mol% meta-cresol as recurring monomeric units are also suitable development accelerators.

In a preferred embodiment, the coating also contains developer resistance means, also called development inhibitors, i.e. one or more ingredients which are capable of delaying the dissolution of the unexposed areas during processing. The dissolution inhibiting effect is preferably reversed by heating, so that the dissolution of the exposed areas is not substantially delayed and a large dissolution differential between exposed and unexposed areas can thereby be obtained. The compounds described in e.g. EP-A 823 327 and WO97/39894 are believed to act as dissolution inhibitors due to interaction, e.g. by hydrogen bridge formation, with the alkali-soluble resin(s) in the coating. Inhibitors of this type typically comprise at least one hydrogen bridge forming group such as nitrogen atoms, onium groups, carbonyl (-CO-), sulfinyl (-SO-) or sulfonyl (-SO₂-) groups and a large hydrophobic moiety such as one or more aromatic rings. Some of the compounds mentioned below, e.g. infrared dyes such as cyanines and contrast dyes such as quaternized triarylmethane dyes can also act as a dissolution inhibitor.

Other suitable inhibitors improve the developer resistance because they delay the penetration of the aqueous alkaline developer into the coating. Such compounds can be present in the first layer and/or, if present, in the second layer as described in e.g. EP-A 950 518, and/or in a development barrier layer on top of said layer, as described in e.g. EP-A 864 420, EP-A 950 517, WO 99/21725 and WO 01/45958. In the latter embodiment, the solubility of the barrier layer in the developer or the penetrability of the barrier layer by the developer can be increased by exposure to heat or infrared light.

Preferred examples of inhibitors which delay the penetration of the aqueous alkaline developer into the coating include the following:
(a) A polymeric material which is insoluble in or impenetrable by the developer, e.g. a hydrophobic or water-repellent polymer or copolymer such as acrylic polymers, polystyrene, styrene-acrylic copolymers, polyesters, polyamides, polyureas, polyurethanes, nitrocellulosics and epoxy resins; or polymers comprising siloxane (silicones) and/or perfluoroalkyl units.
(b) Bifunctional compounds such as surfactants comprising a polar group and a hydrophobic group such as a long chain hydrocarbon group, a poly- or oligosiloxane and/or a perfluorinated hydrocarbon group. A typical example is Megafac F-177, a perfluorinated surfactant available from Dainippon Ink & Chemicals, Inc. A suitable amount of such compounds is between 10 and 100 mg/m², more preferably between 50 and 90 mg/m².
(c) Bifunctional block-copolymers comprising a polar block such as a poly- or oligo(alkylene oxide) and a hydrophobic block such as a long chain hydrocarbon group, a poly- or oligosiloxane and/or a perfluorinated hydrocarbon group. A suitable amount of such compounds is between 0.5 and 25 mg/m², preferably between 0.5 and 15 mg/m² and most preferably between 0.5 and 10 mg/m². A suitable copolymer comprises about 15 to 25 siloxane units and 50 to 70 alkyleneoxide groups. Preferred examples include copolymers comprising phenylmethylsiloxane and/or dimethylsiloxane as well as ethylene oxide and/or propylene oxide, such as Tego Glide 410, Tego Wet 265, Tego Protect 5001 or Silikophen P50/X, all commercially available from Tego Chemie, Essen, Germany. Said poly- or oligosiloxane may be a linear, cyclic or complex cross-linked polymer or copolymer. The term polysiloxane compound shall include any compound which contains more than one siloxane group -Si(R,R')-O-, wherein R and R' are optionally substituted alkyl or aryl groups. Preferred siloxanes are phenylalkylsiloxanes and dialkylsiloxanes. The number of siloxane groups in the polymer or oligomer is at least 2, preferably at least 10, more preferably at least 20. It may be less than 100, preferably less than 60.

It is believed that during coating and drying, the above mentioned inhibitor of type (b) and (c) tends to position itself, due to its bifunctional structure, at the interface between the coating and air and thereby forms a separate top layer even when applied as an ingredient of the coating solution of the first and/or of the optional second layer. Simultaneously, the surfactants also act as a spreading agent which improves the coating quality. The separate top layer thus formed seems to be capable of acting as the above mentioned barrier layer which delays the penetration of the developer into the coating.

Alternatively, the inhibitor of type (a) to (c) can be applied in a separate solution, coated on top of the first, optional second and/or other layers of the coating. In that embodiment, it may be advantageous to use a solvent in the separate solution that is not capable of dissolving the ingredients present in the other layers so that a highly concentrated water-repellent or hydrophobic phase is obtained at the top of the coating which is capable of acting as the above mentioned development barrier layer.

In addition, the first or optional second layer and/or other layer may comprise polymers that further improve the run length and/or the chemical resistance of the plate. Examples thereof are polymers comprising imido (-CO-NR-CO-) pendant groups, wherein R is hydrogen, optionally substituted alkyl or optionally substituted aryl, such as the polymers described in EP-A 894 622, EP-A 901 902, EP-A 933 682 and WO 99/63407.

The coating of the heat-sensitive printing plate precursors described above preferably also contains an infrared light absorbing dye or pigment which, in the embodiment where the coating comprises more than one layer, may be present in the first layer, and/or in the second layer, and/or in an optional other layer. Preferred IR absorbing dyes are cyanine dyes, merocyanine dyes, indoaniline dyes, oxonol dyes, pyrilium dyes and squarilium dyes. Examples of suitable IR dyes are described in e.g. EP-As 823327, 978376, 1029667, 1053868, 1093934; WO 97/39894 and 00/29214. Preferred compounds are the following cyanine dyes:

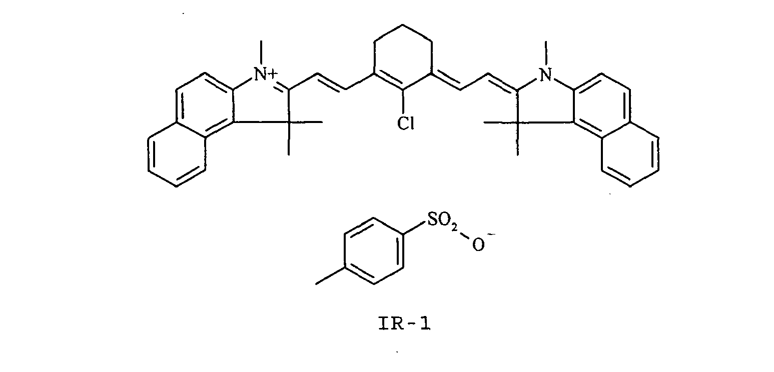

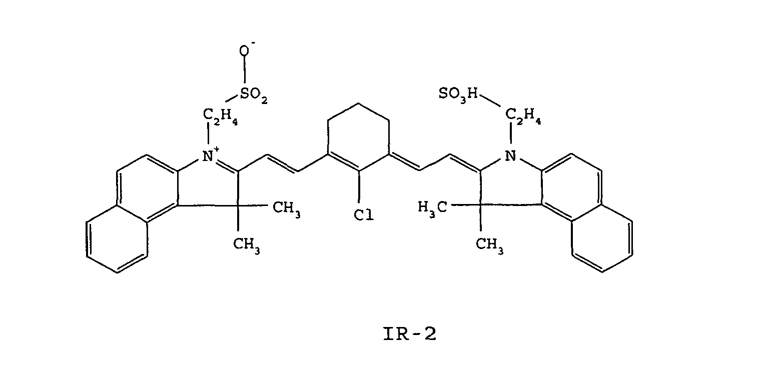

The concentration of the IR-dye in the coating is preferably between 0.25 and 15.0 %wt, more preferably between 0.5 and 10.0 %wt, most preferably between 1.0 and 7.5 %wt relative to the coating as a whole.

The coating may further comprise one or more colorant(s) such as dyes or pigments which provide a visible color to the coating and which remain in the coating at the image areas which are not removed during the processing step. Thereby a visible image is formed and examination of the lithographic image on the developed printing plate becomes feasible. Such dyes are often called contrast dyes or indicator dyes. Preferably, the dye has a blue color and an absorption maximum in the wavelength range between 600 nm and 750 nm. Typical examples of such contrast dyes are the amino-substituted tri- or diarylmethane dyes, e.g. crystal violet, methyl violet, victoria pure blue, flexoblau 630, basonylblau 640, auramine and malachite green. Also the dyes which are discussed in depth in EP-A 400,706 are suitable contrast dyes. Dyes which, combined with specific additives, only slightly color the coating but which become intensively colored after exposure, as described in for example WO2006/005688 may also be used as colorants.

The heat-sensitive plate precursor can be image-wise exposed directly with heat, e.g. by means of a thermal head, or indirectly by infrared light, preferably near infrared light. The infrared light is preferably converted into heat by an IR light absorbing compound as discussed above. The heat-sensitive lithographic printing plate precursor is preferably not sensitive to visible light, i.e. no substantial effect on the dissolution rate of the coating in the developer is induced by exposure to visible light. Most preferably, the coating is not sensitive to ambient daylight.

The printing plate precursor can be exposed to infrared light by means of e.g. LEDs or a laser. Most preferably, the light used for the exposure is a laser emitting near infrared light having a wavelength in the range from about 750 to about 1500 nm, more preferably 750 to 1100 nm, such as a semiconductor laser diode, a Nd:YAG or a Nd:YLF laser. The required laser power depends on the sensitivity of the plate precursor, the pixel dwell time of the laser beam, which is determined by the spot diameter (typical value of modern plate-setters at 1/e² of maximum intensity : 5-25 µm), the scan speed and the resolution of the exposure apparatus (i.e. the number of addressable pixels per unit of linear distance, often expressed in dots per inch or dpi; typical value : 1000-4000 dpi).

Two types of laser-exposure apparatuses are commonly used: internal (ITD) and external drum (XTD) platesetters. ITD plate-setters for thermal plates are typically characterized by a very high scan speed up to 500 m/sec and may require a laser power of several Watts. XTD plate-setters for thermal plates having a typical laser power from about 200 mW to about 1 W operate at a lower scan speed, e.g. from 0.1 to 10 m/sec. An XTD platesetter equipped with one or more laserdiodes emitting in the wavelength range between 750 and 850 nm is an especially preferred embodiment for the method of the present invention.

The known plate-setters can be used as an off-press exposure apparatus, which offers the benefit of reduced press down-time. XTD plate-setter configurations can also be used for on-press exposure, offering the benefit of immediate registration in a multi-color press. More technical details of on-press exposure apparatuses are described in e.g. US 5,174,205 and US 5,163,368.

After exposure, the precursor can be developed by means of a suitable processing liquid, such as an aqueous alkaline solution, whereby the non-image areas of the coating are removed; the development step may be combined with mechanical rubbing, e.g. by using a rotating brush. During development, any water-soluble protective layer present is also removed. The heat-sensitive printing plate precursors based on latex coalescence, can also be developed using plain water or aqueous solutions, e.g. a gumming solution as described in EP 1,342,568. Alternatively, such printing plate precursors can after exposure directly be mounted on a printing press and be developed on-press by supplying ink and/or fountain to the precursor.

More details concerning the development step can be found in for example EP 1614538, EP 1614539, EP 1614540 and WO/2004071767.

### Light-sensitive printing plate precursors.

In addition to the above thermal materials, also light-sensitive coatings can be used. Typical examples of such plates are the UV-sensitive "PS" plates and the so-called photopolymer plates which contain a photopolymerizable composition that hardens upon exposure to light.

In a particular embodiment of the present invention, a conventional, UV-sensitive "PS" plate precursor is used. Suitable examples of such plates precursors, that are sensitive in the range of 300-450 nm (near UV and blue light), have been discussed in EP 1,029,668 A2. Positive and negative working compositions are typically used in "PS" plate precursors.

The positive working imaging layer preferably comprises an o-naphtoquinonediazide compound (NQD) and an alkali soluble resin. Particularly preferred are o-naphthoquinone-diazidosulphonic acid esters or o-naphthoquinone diazidocarboxylic acid esters of various hydroxyl compounds and o-naphthoquinone-diazidosulphonic acid amides or o-naphthoquinone-diazidocarboxylic acid amides of various aromatic amine compounds. Two variants of NQD systems can be used: one-component systems and two-component systems. Such light-sensitive printing plates have been widely disclosed in the prior art, for example in U.S. 3,635,709, J.P. KOKAI No. 55-76346, J.P. KOKAI No. Sho 50-117503, J.P. KOKAI No. Sho 50-113305, U.S. 3,859,099; U.S. 3,759,711; GB-A 739654, US 4,266,001 and J.P. KOKAI No. 55-57841.

The negative working layer of a "PS" plate preferably comprises a diazonium salt, a diazonium resin or an aryldiazosulfonate homo- or copolymer. Suitable examples of low-molecular weight diazonium salts include: benzidine tetrazoniumchloride, 3,3'-dimethylbenzidine tetrazoniumchloride, 3,3'-dimethoxybenzidine tetrazoniumchloride, 4,4'-diaminodiphenylamine tetrazoniumchloride, 3,3'-diethylbenzidine tetrazoniumsulfate, 4-aminodiphenylamine diazoniumsulfate, 4-aminodiphenylamine diazoniumchloride, 4-piperidino aniline diazoniumsulfate, 4-diethylamino aniline diazoniumsulfate and oligomeric condensation products of diazodiphenylamine and formaldehyde. Examples of diazo resins include condensation products of an aromatic diazonium salt as the light-sensitive substance. Such condensation products are described, for example, in DE-P-1 214 086. The light- or heat-sensitive layer preferably also contains a binder e.g. polyvinyl alcohol.

Upon exposure the diazo resins or diazonium salts are converted from water soluble to water insoluble (due to the destruction of the diazonium groups) and additionally the photolysis products of the diazo may increase the level of crosslinking of the polymeric binder or diazo resin, thereby selectively converting the coating, in an image pattern, from water soluble to water insoluble. The unexposed areas remain unchanged, i.e. water-soluble.

Such printing plate precursors can be developed using an aqueous alkaline solution as described above.

In a second suitable embodiment, the light sensitive printing plate precursor is based on a photo-polymerisation reaction and contains a coating comprising a photocurable composition comprising a free radical initiator (as disclosed in for example US 5,955,238; US 6,037,098; US 5,629,354; US 6,232,038; US 6,218,076; US 5,955,238; US 6,037,098; US 6,010,824; US 5,629,354; DE 1,470,154; EP 024,629; EP 107,792; US 4,410,621; EP 215,453; DE 3,211,312 and EP A 1,091,247) a polymerizable compound (as disclosed in EP1,161,4541, EP 1349006, WO2005/109103 and unpublished European patent applications EP 5,111,012.0, EP 5,111,025.2, EP 5110918.9 and EP 5, 110,961.9) and a polymeric binder (as disclosed in for example US2004/0260050, US2005/0003285; US2005/0123853; EP 1,369,232; EP 1,369,231; EP 1,341,040; US 2003/0124460, EP 1 241 002, EP 1 288 720, US 6,027,857, US 6,171,735; US 6,420,089; EP 152,819; EP 1,043, 627; US 6,899,994; US2004/0260050; US 2005/0003285; US2005/0170286; US2005/0123853; US2004/0260050; US2005/0003285; US 2004/0260050; US 2005/0003285; US 2005/0123853 and US2005/0123853). Other ingredients such as sensitizers, coinitiators, adhesion promoting compounds, colorants, surfactants and/or printing out agents may optionally be added. These printing plate precursors can be sensitized with blue, green or red light (i.e. wavelength range between 450 and 750 nm), with violet light (i.e. wavelength range between 350 and 450 nm) or with infrared light (i.e. wavelength range between 750 and 1500 nm) using for example an Ar laser (488 nm) or a FD-YAG laser (532 nm), a semiconductor laser InGaN (350 to 450 nm), an infrared laser diode (830 nm) or a Nd-YAG laser (1064 nm).

Typically, a photopolymer plate precursor is processed in alkaline developer having a pH > 10 (see above) and subsequently gummed. Alternatively, the exposed photopolymer plate precursor can also be developed by applying a gum solution to the coating whereby the non-exposed areas are removed. Suitable gumming solutions are described in WO/2005/111727. After the exposure step, the imaged precursor can also be directly mounted on a press and processed on-press by applying ink and/or fountain solution. Methods for preparing such plates are disclosed in WO 93/05446, US 6,027,857, US 6,171,735, US 6,420,089, US 6,071,675, US 6,245,481, US 6,387,595, US 6,482,571, US 6,576,401, US 6,548,222, WO 03/087939, US 2003/16577 and US 2004/13968.

To protect the surface of the coating of the heat and/or light sensitive printing plate precursors, in particular from mechanical damage, a protective layer may also optionally be applied. The protective layer generally comprises at least one water-soluble binder, such as polyvinyl alcohol, polyvinylpyrrolidone, partially hydrolyzed polyvinyl acetates, gelatin, carbohydrates or hydroxyethylcellulose, and can be produced in any known manner such as from an aqueous solution or dispersion which may, if required, contain small amounts - i.e. less than 5% by weight based on the total weight of the coating solvents for the protective layer - of organic solvents. The thickness of the protective layer can suitably be any amount, advantageously up to 5.0 µm, preferably from 0.1 to 3.0 µm, particularly preferably from 0.15 to 1.0 µm.

Optionally, the coating may further contain additional ingredients such as surfactants, especially perfluoro surfactants, silicon or titanium dioxide particles or polymers particles such as matting agents and spacers.

Any coating method can be used for applying two or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However it is not necessary (and may not even be possible) to remove all the solvent in the drying step. Indeed the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

The heat and/or light sensitive printing plates can be treated with the cleaning liquid used in the present invention. Than, they can be used for conventional, so-called wet offset printing, in which ink and an aqueous dampening liquid are supplied to the plate. Another suitable printing method uses so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705. Also during the printing step the cleaning liquid of the present invention can be applied to the printing plates.

The treating liquid used in the present invention can also be used for treating thermo-resists, for example on a PCB (printed circuit board) application as described in US 2003/0003406 A1.

### EXAMPLES

### EXAMPLE 1

### 1. Preparation of the comparative plate cleaner PC-01.

A comparative plate cleaner PC-01 with the composition given in Table 1 was prepared as follows.

### Preparation of the aqueous phase:

Phosphoric acid 85 %wt is added to demineralized water, followed by sorbitol and Glucopon. Then Parmetol A26 is added while mixing until all components are completely dissolved.

### Preparation of the solvent phase:

Isopropyl laurate is added to Shellsoll D-60 at room temperature and stirred until it is fully dissolved.

### Preparation of the emulsion.

While stirring @15K revolutions/minute in an Ultra Turrax T25 digital mixture, equipped with a S25N mixing head (both from IKA Werke GmbH& Co) the solvent phase is slowly added into the vortex of the aqueous phase. After complete addition of the organic part, the resulting emulsion was stirred for an additional 2 minutes at the same speed.

Finally, Rheogel IRX55395 was added to this emulsion and the resulting plate cleaner was stirred for an additional 30 minutes using a stirrer (RW20 from IKA Werke GmbH & Co) equipped with a dispersion disk (R1303 from IKA Werke GmbH & Co). The rotational speed was gradually increased in order to account for the increasing viscosity.

The composition of the comparative plate cleaner PC-01 is given in Table 1. Table 1: composition of comparative plate cleaner PC-01.

| Ingredients | g |
|---|---|
| **Aqueous Phase** | |
| Demineralized water | 160 |
| Sorbitol (1) | 20 |
| Parmetol A26 (2) | 0.4 |
| Glucopon 600 CSUP (3) | 12.8 |
| Phosphoric acid 85 %wt | 8 |
| Total aqueous phase | 201.2 |

| **Solvent Phase** | |
|---|---|
| Shellsoll D-60 (4) | 60 |
| Isopropyl laurate | 20 |
| Total solvent phase | 80 (28.3%wt) |

| **Emulsion** | |
|---|---|
| Rheogel IRX55395 (5) | 1.0 |
| **Total** | 282.2 |

(1) 70 %wt solution of sorbitol from Roquette Frères SA (France). 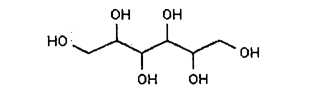
(2) biocide, trade name of Schülke & Maier GmbH (Germany);
(3) alkylpolyglucoside from Cognis; C₁₂-C₁₄ and average number of glucoside units = 1.4;
(4) aliphatic hydrocarbon solvent commercially available from Shell; flash point higher than 60°C;
(5) xhantangum thickener commercially available from CNI SA (France).

The solvent level of the comparative plate cleaner is 28.3 %wt.

### 2. Preparation of inventive plate cleaner PC-02.

The inventive plate cleaner PC-02 with the composition given in Table 2 was prepared following the same modus as for the comparative plate cleaner PC-01 except that Pluriol A1350 P was added to the aqueous phase.

**Table 2: composition of the inventive plate cleaner PC-02.**

| Ingredients | g |
|---|---|
| **Aqueous Phase** | |
| Demineralized water | 160 |
| Sorbitol (1) | 20 |
| Parmetol A26 (2) | 0.4 |
| Glucopon 600 CSUP (3) | 12.8 |
| Phosphoric acid 85 %wt | 8 |
| Pluriol A1350 P (4) | 3 |
| Total aqueous phase | 204.2 |

| **Solvent Phase** | |
|---|---|
| Shellsoll D-60 (5) | 60 |
| Isopropyl laurate | 20 |
| Total solvent phase | 80 (28.0 %wt) |

| **Emulsion** | |
|---|---|
| Rheogel IRX 55395 (6) | 1 |
| **Total** | **285.2** |

| | |
|---|---|
| (1), (2), (3), (5) and (6): see Table 1; (4) mono-butyl polypropyleenoxide; n=20, Mw = 1350 g/mol; commercially available from BASF; | |

The solvent level of this plate cleaner is 28.0 %wt.

### 3. Evaluation of the plate cleaners PC-01 and PC-02.

Both plate cleaners PC-01 and PC-02 formed stable emulsions and their cleaning efficiency in terms of their capability to remove ink from a printing plate (ink solvency) was subsequently evaluated.

Both the comparative plate cleaner PC-01 and the plate cleaner according to the present invention PC-02, and a reference plate cleaner PC-03 - i.e. Normakleen RC910; trademark of Agfa Graphics, comprising 45%wt of a solvent phase containing 60%wt Solvesso 100 (trademark of Exxonmobil Chemical) and 40%wt Shellsol 40 (trademark of Shell) - were evaluated using a printing plate Thermostar P970 (trademark of Agfa Graphics) on a Heidelberg Speedmaster SM74 printing press (available from Heidelberger Druckmaschinen AG) using the following printing conditions:
- ink: K+E 700 black ink (trademark of K&E).
- fountain solution: 4% Agfa Prima FS303 (trademark of Agfa-Graphics) + 10% isopropanol.
- paper: machine-coated paper (90 g/m²).

The cleaning efficiency of the plate cleaners PC-01, PC-02 and of the reference plate cleaner PC-03 was independently evaluated by a panel of 6 press operators using common plate cleaning procedures. A small amount (about 60ml) of each plate cleaner was applied on a spongue (wetted with fountain solution) and subsequently this spongue was used to clean the plate on the press.

Plate cleaner PC-01 was unanimously evaluated as being inferior to plate cleaners PC-02 and PC-03 with regard to its cleaning efficiency and ink solvency. The results are given in Table 3.

**Table 3: ink solvency (IS).**

| Plate Cleaner | ink solvency* |
|---|---|
| PC-01 | 2 |
| comparative | |
| PC-02 | 4 |
| inventive | |
| PC-03 | 5 |
| reference | |

| | |
|---|---|
| * the following qualitative ink solvency (IS) scale was used: 1 = very poor 2 = poor 3 = not acceptable yet 4 = good 5 = very good | |

### EXAMPLE 2.

### 1. Preparation of plate cleaners PC-04 to PC-08.

Plate cleaner formulations PC-04 to PC-08 were made in the same way as PC-02, using polypropylene glycol ethers as given in Table 4.

The plate cleaner formulations were first evaluated with respect to emulsion stability (ES). The ES was evaluated as follows:

The stability of the emulsion was evaluated using a Lumisizer 610 apparatus (available from LUM GmbH (Germany). The stability is evaluated as follows:

A measuring cell (cuvette) is submitted to high G-forces by means of a centrifuge. The full length of the cuvette is analyzed by measuring the transmittance of NIR light (CCD sensor). As a result of this, a profile of transmitted light is recorded over the full length of the cell during centrifugation. Any change in the upper meniscus is monitored.

The rotational speed was 640 rpm and the total duration of the test was 9 hours and 45 minutes. At set intervals, the cuvette profile is recorded and plotted graphically.

For a stable emulsion, the resulting graphs should all show no changes over the complete length of the curve, indicating that no phase separation took place on the top and/or bottom side of the emulsion in the cuvette. This indicates that no splitting, creaming or sedimentation has occurred during the experiment.

**Table 4: composition of the plate cleaners PC-04 to PC-08.**

| | | | | | |
|---|---|---|---|---|---|
| Ingredients g | PC-04 *inv.* | PC-05 *inv.* | PC-06 *comp.* | PC-07 *comp.* | PC-08 *comp.* |

| **Aqueous Phase** | | | | | |
|---|---|---|---|---|---|
| Demineralized water | 160 | 160 | 160 | 160 | 160 |
| Sorbitol (1) | 20 | 20 | 20 | 20 | 20 |
| Parmetol A26 (2) | 0.4 | 0.4 | 0.4 | 0.4 | 0.4 |
| Phosphoric acid 85 %wt | 8 | 8 | 8 | 8 | 8 |
| Glucopon 600 SCUP (3) | 3 | 3 | 3 | 3 | 3 |
| Total aqueous phase | 191.4 | 191.4 | 191.4 | 191.4 | 191.4 |

| **Solvent Phase** | | | | | |
|---|---|---|---|---|---|
| Shellsoll D-60 (4) | 40 | 40 | 40 | 40 | 40 |
| Pluriol A1350 P(5) | 40 | - | - | - | - |
| Polyglycol B01/20 (6) | - | 40 | - | - | - |
| Polyglycol T01/35 (7) | - | - | 40 | - | - |
| Dowanol TPnB (8) | - | - | - | 40 | - |
| Dowanol DPnB (9) | - | - | - | - | 40 |
| Total solvent phase | 80 29.25%wt | 80 29.25%wt | 80 29.25%wt | 80 29.25%wt | 80 29.25%wt |

| **Thickener** | | | | | |
|---|---|---|---|---|---|
| Rheogel IRX 55395 (9) | 2 | 2 | 2 | 2 | 2 |

| | | | | | |
|---|---|---|---|---|---|
| (1), (2), (3), (4) and (5): see Table 1; (6) mono-butyl polypropyleenoxide; n=14, commercially available from Clariant GmbH; (7) C₁₃ polypropyleenoxide; n=11, commercially available from Clariant GmbH; (8) mono-butyl polypropyleenoxide; n=3, commercially available from Dow;µ (9) mono-butyl polypropyleenoxide; n=2, commercially available from Dow. | | | | | |

The results of the emulsion stability evaluation are given in Table 5.

Only the plate cleaners PC-04 and PC-05 showed an acceptable emulsion stability. These plate cleaner formulations subsequently were evaluated with respect to their cleaning efficiency (ink solvency) as outlined in Example 1. The results are also given in Table 5.

**Table 5: emulsion stability (ES) and ink solvency (IS).**

| Plate Cleaner | RO-(Y)ₙ-H⁽¹⁾ | Y | n | R | ES⁽²⁾ ES | IS⁽³⁾ IS |
|---|---|---|---|---|---|---|
| PC-04 Inv. | Pluriol A1350 P | PPO | 20 | C₄ | OK | 5 |
| PC-05 Inv. | Polyglycol B01/20 | PPO | 14 | C₄ | OK | 5 |
| PC-06 *Comp.* | Polyglycol T01/35 | PPO | 11 | C₁₃ | Not OK | nd⁽⁴⁾ |
| PC-07 Comp. | Dowanol TPnB | PPO | 3 | C₄ | Not OK | nd⁽⁴⁾ |
| PC-08 Comp. | Dowanol DPnB | PPO | 2 | C₄ | Not OK | nd⁽⁴⁾ |

| | | | | | | |
|---|---|---|---|---|---|---|
| (1): see Table 4; (2): emulsion stability; (3): ink solvency; ink solvency scale: see table 3; (4): not determined. | | | | | | |

From the results in Table 5 it can be derived that an emulsion plate cleaner formulation comprising less than 40%wt of a non-aromatic solvent is stable and well performing in terms of both emulsion stability and ink solvency when the polypropylene glycol ethers are characterized by an R group alkyl shorter than or equal to butyl, and an polypropoxylate part equal to or larger than 10 units.

## Claims

1. A method for cleaning a lithographic printing plate comprising the step of applying a liquid to the plate including
(i) an aqueous phase;
(ii) a solvent phase which is present in the liquid in an amount ≤ 40%wt;
(iii) and one or more compound(s) having the following formula:
R¹-O-(Y)ₙ-H
wherein
R¹ is a methyl group, an ethyl group, a propyl group or a butyl group;
Y represents -CH₂-CHR²-O- with R² = hydrogen or an alkyl group and/or mixtures thereof;
and n is an integer ≥ 10.

2. Method according to claim 1 wherein Y represents ethylene oxide and/or propylene oxide.

3. Method according to claim 2 wherein the molar fraction of ethylene oxide in the ethylene oxide/propylene oxide mixture is ≤ 0.5.

4. Method according to any of the preceding claims wherein Y is propylene oxide.

5. Method according to any of the preceding claims wherein the solvent phase is present in the liquid in an amount ≤ 30%wt.

6. Method according to any of the preceding claims wherein the solvent phase comprises aliphatic hydrocarbons and/or esters of vegetable oils.

7. Method according to any of the preceding claims wherein the aliphatic hydrocarbons are selected from linear or branched C₇-C₁₄ hydrocarbons.

8. Method according to any of the preceding claims wherein the liquid has a flash point ≥ 60°C.

9. Method according to any of the preceding claims wherein the printing plate is obtained by exposing and developing a printing plate precursor comprising a coating including an oleophilic resin which is soluble in an aqueous alkaline developer.

## Patentansprüche

1. Ein Verfahren zur Reinigung einer lithografischen Druckplatte, umfassend den Schritt, in dem eine die folgenden Bestandteile enthaltende Flüssigkeit auf die Platte angebracht wird :
(i) eine wässrige Phase,
(ii) eine Lösungsmittelphase, die in einer Menge ≤ 40 Gew.-% in der Flüssigkeit enthalten ist,
(iii) und eine oder mehrere Verbindungen gemäß der folgenden Formel :
R¹-O-(Y)ₙ-H
in der :
R¹ eine Methylgruppe, eine Ethylgruppe, eine Propylgruppe oder eine Butylgruppe bedeutet,
Y -CH₂-CHR²-O- bedeutet, wobei R² ein Wasserstoffatom oder eine Alkylgruppe und/oder Gemische derselben bedeutet, und
n eine ganze Zahl ≥ 10 bedeutet.

2. Verfahren nach Anspruch 1, **dadurch gekennzeichnet, dass** Y Ethylenoxid und/oder Propylenoxid bedeutet.

3. Verfahren nach Anspruch 2, **dadurch gekennzeichnet, dass** die Molfraktion des Ethylenoxids im Gemisch aus Ethylenoxid und Propylenoxid ≤ 0,5 beträgt.

4. Verfahren nach einem der vorstehenden Ansprüche, **dadurch gekennzeichnet, dass** Y Propylenoxid bedeutet.

5. Verfahren nach einem der vorstehenden Ansprüche, **dadurch gekennzeichnet, dass** die Lösungsmittelphase in einer Menge ≤ 30 Gew.-% in der Flüssigkeit enthalten ist.

6. Verfahren nach einem der vorstehenden Ansprüche, **dadurch gekennzeichnet, dass** die Lösungsmittelphase alifatische Kohlenwasserstoffe und/oder Ester pflanzlicher Öle enthält.

7. Verfahren nach einem der vorstehenden Ansprüche, **dadurch gekennzeichnet, dass** die alifatischen Kohlenwasserstoffe geradkettige oder verzweigtkettige C₇-C₁₄-Kohlenwasserstoffe sind.

8. Verfahren nach einem der vorstehenden Ansprüche, **dadurch gekennzeichnet, dass** die Flüssigkeit einen Flammpunkt ≥ 60°C hat.

9. Verfahren nach einem der vorstehenden Ansprüche, **dadurch gekennzeichnet, dass** die Druckplatte durch Belichtung und Entwicklung einer Druckplattenvorstufe, die eine ein oleophiles, in einem wässrig-alkalischen Entwickler lösliches Harz enthaltende Beschichtung umfasst, erhalten wird.

## Revendications

1. Un procédé pour le nettoyage d'une plaque d'impression lithographique, comprenant l'étape consistant à appliquer sur la plaque un liquide contenant :
(i) une phase aqueuse,
(ii) une phase de solvant contenue dans le liquide dans une quantité ≤ 40% en poids,
(iii) et au moins un composé répondant à la formule ci-après :
R¹-O-(Y)ₙ-H
où :
R¹ représente un groupe méthyle, un groupe éthyle, un groupe propyle ou un groupe butyle,
Y représente -CH₂-CHR²-O-, où R² représente un atome d'hydrogène ou un groupe alkyle et/ou des mélanges de ceux- ci, et
n représente un nombre entier ≥ 10.

2. Procédé selon la revendication 1, **caractérisé en ce que** Y représente de l'oxyde d'éthylène et/ou de l'oxyde de propylène.

3. Procédé selon la revendication 2, **caractérisé en ce que** la fraction molaire d'oxyde d'éthylène dans le mélange composé d'oxyde d'éthylène et d'oxyde de propylène s'élève à ≤ 0,5.

4. Procédé selon l'une quelconque des revendications précédentes, **caractérisé en ce que** Y représente de l'oxyde de propylène.

5. Procédé selon l'une quelconque des revendications précédentes, **caractérisé en ce que** la phase de solvant est contenue dans le liquide dans une quantité de ≤ 30% en poids.

6. Procédé selon l'une quelconque des revendications précédentes, **caractérisé en ce que** la phase de solvant contient des hydrocarbures aliphatiques et/ou des esters d'huiles végétales.

7. Procédé selon l'une quelconque des revendications précédentes, **caractérisé en ce que** les hydrocarbures aliphatiques sont choisis parmi le groupe composé d'hydrocarbures en C₇-C₁₄ à chaîne linéaire ou à chaîne ramifiée.

8. Procédé selon l'une quelconque des revendications précédentes, **caractérisé en ce que** le liquide présente un point d'inflammation ≥ 60°C.

9. Procédé selon l'une quelconque des revendications précédentes, **caractérisé en ce que** la plaque d'impression est obtenue par exposition et développement d'un précurseur de plaque d'impression comprenant un revêtement contenant une résine oléophile soluble dans un révélateur alcalin aqueux.
